**Europäisches Patentamt**

**European Patent Office**

**Office européen des brevets**

(11) Veröffentlichungsnummer : **0 121 845**
**B1**

(12) **EUROPÄISCHE PATENTSCHRIFT**

(45) Veröffentlichungstag der Patentschrift :
11.11.87

(51) Int. Cl.⁴ : **H 03 K 17/975**

(21) Anmeldenummer : **84103256.8**

(22) Anmeldetag : **23.03.84**

(54) **Elektromechanischer Wandler.**

(30) Priorität : **08.04.83 DE 3312689**

(43) Veröffentlichungstag der Anmeldung :
**17.10.84 Patentblatt 84/42**

(45) Bekanntmachung des Hinweises auf die Patenterteilung : **11.11.87 Patentblatt 87/46**

(84) Benannte Vertragsstaaten :
**AT CH DE FR GB IT LI NL SE**

(56) Entgegenhaltungen :
**DE-A- 1 524 532**
**DE-A- 2 241 587**

(73) Patentinhaber : **Siemens Aktiengesellschaft Berlin und München**
**Wittelsbacherplatz 2**
**D-8000 München 2 (DE)**

(72) Erfinder : **Schewe, Herbert, Dr.**
**Haydn-Strasse 58**
**D-8522 Herzogenaurach (DE)**
Erfinder : **Schnittger, Jens**
**Kutzerstrasse 98**
**D-8510 Fürth (DE)**

Jouve, 18, rue St-Denis, 75001 Paris, France

## Beschreibung

Die Erfindung bezieht sich auf einen elektromechanischen Wandler mit einem flachen, dünnen Dielektrikum, an dessen einer Flachseite eine scheibenförmige Elektrode aus einem elektrisch leitenden Elastomer in einem vorbestimmten, durch Druck veränderbaren Abstand angeordnet ist. An der anderen Flachseite liegen eine Eingangselektrode und eine Ausgangselektrode an, die jeweils mit elektrischen Anschlußleitern versehen sind.

Es sind Tasten auf kapazitiver Basis bekannt, bei denen das Zusammenpressen eines Dielektrikums eine sprunghafte Kapazitätsänderung bewirkt, die mit Hilfe geeigneter Schaltungen in Impulse umgesetzt und einer Elektronik zugeführt wird. Solche Taster ohne mechanische Kontakte haben eine hohe Lebensdauer.

Bei einer bekannten Ausführungsform einer kapazitiven Taste mit einer PVDF-Folie als Dielektrikum und drei Elektroden, die eine Reihenschaltung von Kapazitäten bilden, ist die erste Elektrode in einem vorbestimmten Abstand von der Oberfläche der PVDF-Folie angeordnet. Das Schaltsignal entsteht durch Abstandsänderung der ersten Elektrode zum Dielektrikum und damit zur zweiten und dritten Elektrode. Die zweite und dritte Elektrode sind auf der anderen Flachseite der PVDF-Folie nebeneinander angeordnet (deutsches Gebrauchsmuster 8 229 410).

In dieser bekannten Ausführungsform ist die bewegliche erste Elektrode im allgemeinen scheibenförmig und als Überbrückungselektrode für die beiden anderen Elektroden ausgeführt. Die beiden anderen Elektroden dienen als Eingangs- bzw. Ausgangselektrode und sind im allgemeinen in der Form einer Halbkreisscheibe gestaltet. Die Fläche dieser beiden Elektroden einschließlich der Fläche ihres Zwischenraumes wird etwa durch die scheibenförmige erste Elektrode abgedeckt, die bei Betätigung der Taste in der Richtung senkrecht zur Oberfläche der PVDF-Folie und senkrecht zur Ausdehnung der zweiten und dritten Elektrode geführt wird. Diese Anordnung kann bei nicht genau senkrechter Führung der ersten Elektrode dazu führen, daß bei Betätigung der Taste die beiden durch die Elektroden in Serie geschalteten Kapazitäten unterschiedliche Größe haben, so daß die wirksame Kopplungskapazität zwischen Eingangs- und Ausgangselektrode entsprechend vermindert wird. Eine an die Eingangselektrode angelegte Wechselspannung wird in diesem Fall an der Ausgangselektrode nur abgeschwächt auftreten, so daß unter Umständen eine sichere Schaltfunktion der Taste nicht mehr gewährleistet ist.

Der Erfindung liegt nun die Aufgabe zugrunde, die Sicherheit der Schaltfunktion der Taste zu erhöhen und einen Kapazitätsverlust bei Betätigung der Taste zu vermeiden.

Eine weitere bekannte kapazitive Taste enthält ebenfalls eine Eingangs- und eine Ausgangselektrode, die jeweils als Halbkreisscheibe gestaltet und auf einer Flachseite einer als Dielektrikum dienenden dünnen Folie angeordnet sind. Auf der gegenüberliegenden Flachseite ist mit Abstand die dritte Elektrode angeordnet, deren Bewegung durch einen Tastenknopf die zum Schalten erforderliche Kapazitätsänderung bewirkt. Diese dritte Elektrode ist ringförmig gestaltet, so daß nur ein Teil der Flächen der Eingangs- und Ausgangselektroden zur Signalerzeugung ausgenutzt wird (DE-A1-1 524 532).

Es ist außerdem ein kapazitiver Schalter mit zwei Elektroden bekannt, von denen eine beweglich ist. Diese bewegliche Elektrode ist als kuppelartige Feder in der Form eines hohlen geometrischen Festkörpers mit gewölbter Oberfläche gestaltet, die mit Schnappwirkung arbeitet. Sie besteht aus rostfreiem Stahl.

Eine sehr dünne Auflage der Gegenelektrode dient als Dielektrikum, das somit durch die Schnappwirkung der ersten Elektrode mechanischer Beanspruchung ausgesetzt ist. Die Gegenelektrode kann auch aus konzentrischen scheiben- und ringförmigen Teilelektroden bestehen, die jedoch schwierig zu kontaktieren sind (DE-A1-2 241 587).

Die erwähnte Aufgabe wird nun erfindungsgemäß gelöst mit den kennzeichnenden Merkmalen des Anspruchs 1. Bei dieser Gestaltung des Wandlers bleiben auch bei nicht axialer Führung der ersten Elektrode die durch die Elektroden gebildeten wirksamen Kondensatorflächen unverändert. Deshalb kann der Schaltzustand dieser Taste unabhängig von unvermeidlichen Fertigungstoleranzen zuverlässig erkannt werden. Außerdem erhält man mit dieser Ausführungsform eine sehr empfindliche Taste, die bei Betätigung eine Kapazitätserhöhung um mehr als eine Größenordnung bewirkt.

Zur weiteren Erläuterung der Erfindung wird auf die Zeichnung Bezug genommen, in deren Figur 1 ein Ausführungsbeispiel eines elektromechanischen Wandlers nach der Erfindung als Schnittbild schematisch veranschaulicht ist. Figur 2 zeigt die Eingangs- und Ausgangselektrode in einer Draufsicht und in den Figuren 3 und 4 ist jeweils eine besondere Ausführungsform der Elektroden dargestellt.

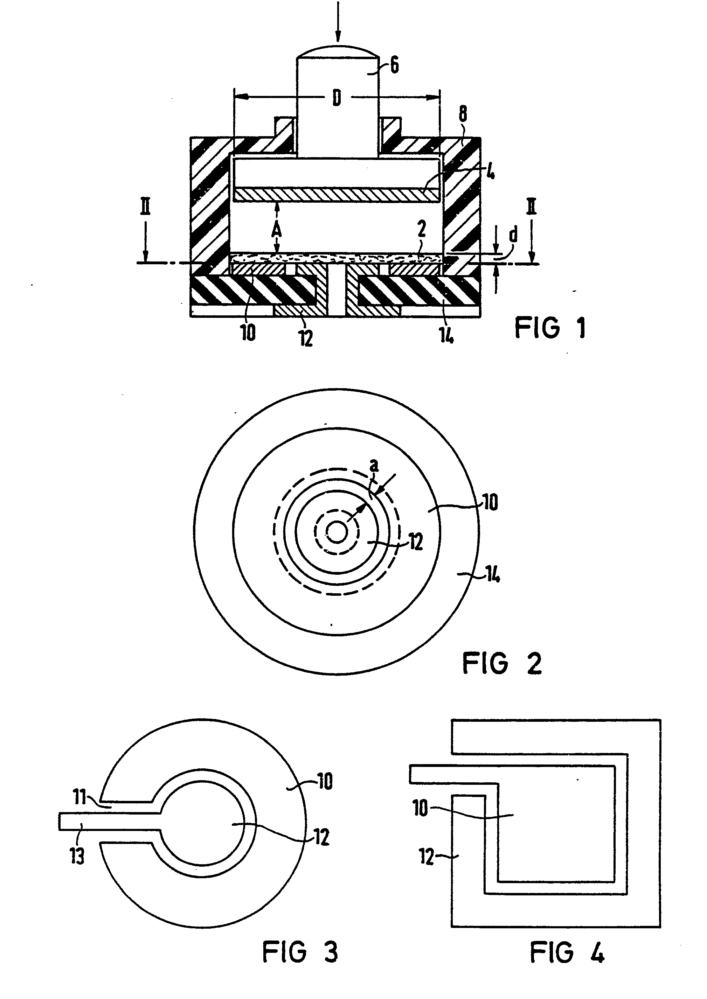

In der Ausführungsform nach Figur 1 ist ein flaches, dünnes Dielektrikum vorgesehen, das beispielsweise aus einer Folie aus Polyvinylidenfluorid PVDF mit einer Dicke d von beispielsweise etwa 10 μm bestehen kann. Dem Dielektrikum 2 ist eine erste Elektrode 4 zugeordnet, die vorzugsweise aus einem elektrisch leitenden Elastomer bestehen kann und in einem vorbestimmten Abstand A von der oberen Flachseite des Dielektrikums 2 beweglich angeordnet ist. Die erste Elektrode 4 kann vorzugsweise als Scheibe mit einem Durchmesser D von beispielsweise etwa 3 mm gestaltet sein. Sie ist an einem Knopf 6 befestigt, der in einem Gehäuse 8 senkrecht zur Flachseite des Dielektrikums 2 beweglich geführt ist und im allgemeinen mit in der Figur nicht dargestellten Mitteln zur Rückführung in seine Ruhelage versehen ist. An der unteren Flachseite des Dielektrikums 2 liegt eine Eingangselektrode 10 an, die eine Ausgangselektrode 12 wenigstens teilweise umgibt. Die Eingangs- und Ausgangselektroden 10 bzw. 12 sind auf einer Leiterplatte 14 angeordnet und jeweils mit in der Figur nicht dargestellten elektrischen Anschlußleitern versehen.

Die Ausgangselektrode 12 ist von der Eingangselektrode 10 im Abstand a konzentrisch umgeben, wie der Darstellung nach Figur 2 zu entnehmen ist. Im Zentrum der Ausgangselektrode 12 ist die Leiterplatte 14 mit einer nicht näher bezeichneten Bohrung versehen. Die zylindrische Innenwand dieser Bohrung und der an die Bohrung angrenzende Bereich der unteren Flachseite der Leiterplatte 14 sind mit elektrisch leitendem Material versehen, an dem in einfacher Weise ein Anschlußleiter befestigt werden kann.

In der Ausführungsform nach Figur 3 ist die Eingangselektrode 10 mit einer Durchbrechung 11 versehen, durch die ein Anschlußleiter 13 der Ausgangselektrode 12 hindurchgeführt werden kann. In dieser Ausführungsform ist somit ein Durchkontaktieren der inneren Elektrode durch eine entsprechende Bohrung der Leiterplatte 14 nicht erforderlich.

Im Ausführungsbeispiel wurde die äußere Elektrode 10 als Eingangselektrode und die innere Elektrode 12 als Ausgangselektrode gewählt. In gleicher Weise kann jedoch auch die innere Elektrode als Eingangs- und die äußere Elektrode als Ausgangselektrode gewählt werden. In dieser Ausführungsform des elektromechanischen Wandlers bleiben auch bei nicht axialer Führung der ersten Elektrode 4 und entsprechend der Verschiebung dieser Elektrode aus dem Zentrum der Eingangs- und Ausgangselektroden die wirksamen Kondensatorflächen wenigstens annähernd unverändert.

In der im Ausführungsbeispiel nach den Figuren 2 und 3 dargestellten Ausführungsform ist die Ausgangselektrode 12 von der Eingangselektrode 10 konzentrisch umgeben. Es kann jedoch mit der gleichen Wirkung auch die Eingangs- von der Ausgangselektrode umgeben sein. Ferner ist es nicht erforderlich, daß die Elektroden als Kreisscheibe bzw. Ringscheibe gestaltet sind ; es kann beispielsweise eine innere quadratische oder rechteckige Eingangselektrode 10 auch von einer ebenso eckigen Rahmenelektrode umgeben sein, die als Ausgangselektrode 12 dient, wie es in Figur 4 dargestellt ist.

**Patentanspruch**

Elektromechanischer Wandler mit einem flachen, dünnen Dielektrikum (2), an dessen einer Flachseite eine scheibenförmige Elektrode (4) aus einem elektrisch leitenden Elastomer in einem vorbestimmten, durch Druck veränderbaren Abstand (A) angeordnet ist und an dessen anderer Flachseite eine Eingangselektrode (10) und eine Ausgangselektrode (12) anliegen, die jeweils mit elektrischen Anschlußleitern versehen sind, dadurch gekennzeichnet, daß die Eingangselektrode (10) und die Ausgangselektrode (12) im wesentlichen konzentrisch zueinander angeordnet sind.

**Claim**

An electro-mechanical transducer having a flat, thin dielectric (2), at one flat face of which a disc-shaped electrode (4) consisting of an electrically-conductive elastomer is arranged spaced by a predetermined gap (A) which can be varied by means of pressure, and the other flat face of the dielectric having applied an input electrode (10) and an output electrode (12), each of which is provided with electrical terminals, characterised in that the input electrode (10) and the output electrode (12) are arranged fundamentally concentric with one another.

**Revendication**

Transducteur électro-mécanique avec un diélectrique plan et mince (2) sur le côté de l'une des faces planes duquel une électrode de la forme d'un disque (4) en un élastomère électriquement conducteur, est disposée à une distance déterminée (A) susceptible d'être modifiée par la pression, alors que contre l'autre surface plane portent une électrode d'entrée (10) et une électrode de sortie (12) pourvues chacune de conducteurs électriques de branchement, caractérisé par le fait que l'électrode d'entrée (10) et l'électrode de sortie (12) sont disposées sensiblement de façon concentrique entre elles.

FIG 1

FIG 2

FIG 3

FIG 4